# EUROPEAN PATENT SPECIFICATION

(11) **EP 0 702 432 B1**
(45) Date of publication and mention of the grant of the patent: **24.02.1999**
(21) Application number: 95111862.9
(22) Date of filing: 27.07.1995
(51) Int. Cl.: H01R 23/68

(54) **Connector for a printed circuit board**
Stecker für Leiterplatte
Connecteur pour carte imprimée

(30) Priority: 16.09.1994 JP 248670/94
(43) Date of publication of application: 20.03.1996
(73) Proprietor: SUMITOMO WIRING SYSTEMS, LTD., Yokkaichi City Mie 510 (JP)
(72) Inventor: Okumura, Hitoshi c/o Sumitomo Wiring Sys., LTD., Yokkaichi-City, Mie 510 (JP); Tokuwa, Koichiro c/o Sumitomo Wiring Syst., LTD., Yokkaichi-City, Mie 510 (JP); Kuki, Heiji c/o Sumitomo Wiring Syst., LTD., Yokkaichi-City, Mie 510 (JP)
(74) Representative: Müller-Boré & Partner Patentanwälte

(56) References cited:
- DE-A- 2 921 805
- DE-A- 3 032 585
- DE-A- 3 430 573
- US-A- 5 147 225
- US-A- 5 306 162

## Description

### DETAILED DESCRIPTION OF THE INVENTION

The present invention relates to a connector to be connected with a printed circuit board.

The connector is electrically connected with the printed circuit board by inserting leading ends of a plurality of lead terminals into through holes of the printed circuit board. Accordingly, it is difficult to insert the lead terminals into the through holes of the printed circuit board if the leading ends of the plurality of lead terminals face in different directions.

In view of this, a connector provided with a positioning member for aligning the leading ends of a plurality of lead terminals has been used in recent years.

A connector with the features of the precharacterising portion of claim 1 is disclosed in Japanese Unexamined Patent Publication No. 4-179078. This connector is shown in FIGS. 16(a) to 16(c), and includes a housing 1 having a plurality of lead terminals 2 which project from the housing 1 and are bent in an L-shape to extend downward, and a positioning member 3 formed with insertion holes 4 into which downwardly facing leading ends 2a of the respective lead terminals 2 are insertable. A pair of guide walls 5, 5 are formed at opposite lateral sides of the front surface of the housing 1 from which the lead terminals 2 project. On guide surfaces 5a, 5a of the guide walls 5, 5 which are opposed to each other, there are formed locking projections 6a and 6b for retaining the positioning member 3 in a partial mount position and a full mount position, respectively. On the other hand, a pair of wall-like engaging members 7, 7 stand upright at opposite lateral sides from a plate-like main body 3a of the positioning member 3 where the insertion holes 4 are formed. An engaging projection 7a engageable with the locking projections 6a and 6b is formed at the outer surface of each engaging member 7.

The positioning member 3 is mounted on the housing 1 by fitting the engaging members 7 thereof along the guide surfaces 5a from below, and is held in its partial mount position when the engaging projections 7a moves over the lower locking projection 6b. In this state, the leading ends 2a of the respective lead terminals 2 are slightly inserted into the insertion holes 4 so that they can be positioned in conformity with unillustrated through holes of the printed circuit board. Further, since the leading ends 2a of the lead terminals 2 are concealed in the positioning member 3, they are kept free from a damage caused by an external force.

In order to mount the connector on the printed circuit board in this state, the leading ends 2a of the lead terminals 2 are caused to project downwardly from the insertion holes 4 by moving the positioning member 3 from its partial mount position to its full mount position. When the connector is mounted in a specified position on the printed circuit board, all the leading ends 2a of the lead terminals 2 positioned in the insertion holes 4 are inserted into the through holes of the printed circuit board at the same time.

In the aforementioned prior art connector, when the positioning member 3 mounted on the housing 1 is moved to the partial mount position, and is moved from the partial mount position to the full mount position, the engaging members 7 are inwardly deflected as the engaging projections 7a thereof move over the locking projections 6a and 6b of the guide walls 5.

Upon being deflected, the engaging members 7 themselves undergo an elastic deformation and also cause the plate-like main body 3a of the positioning member 3 to undergo an elastic deformation. The insertion holes 4 formed in the main body 3a as described above are slightly deformed and disarranged as the main body 3a is deflected. The deformation and the disarrangement of the insertion holes 4 are to be avoided in order to correctly align the leading ends 2a of the lead terminals 2.

In view of the above problem, it is an object of the invention to minimize a deformation of a positioning member when it is moved relative to a housing.

The above object is accomplished by a connector as defined in claim 1.

In the invention as constructed above, when the positioning member is mounted on the housing or moved between its partial mount position and its full mount position, the engaging members of the positioning member undergo an elastic deformation toward the outside, away from the guide members of the housing, because of the presence of the projections forming the retaining means. The elastic deformation of the engaging members causes a deformation of a portion of the positioning member where the insertion holes are formed.

However, the engaging members are located at the outside of the guide surfaces formed on the outer surfaces of the housing. Accordingly, a spacing between the engaging members according to the invention is longer, compared to the prior art connector in which the engaging members are located on the inside of the inward facing guide surfaces formed on the housing. Thus, a deformation per unit length of the positioning member caused by the deformation of the engaging members can be suppressed to a smaller degree.

As described above, according to the invention, since the deformation per unit length of the positioning member is suppressed by locating the engaging members of the positioning member on the outside of the outward facing guide surfaces, the deformation and the disarrangement of the insertion holes caused by the deformation of the positioning member are also suppressed to a considerably small degree. Accordingly, the invention is fairly free from adverse influences brought about by the deformation and the disarrangement of the insertion holes, thus realizing a highly accurate aligning function.

Preferably, the connector further comprises screwing means which is preferably formed by at least one screw which is inserted from the underneath of a printed circuit board and is spirally engaged with the positioning member or the housing.

Since the screwing means inserted from the underneath of the printed circuit board is spirally engaged with the positioning member or the housing, the connector gradually comes closer to the printed circuit board as screws are turned.

As the connector is caused to gradually move closer to the printed circuit board by the screwing means, the connector can be securely mounted on the printed circuit board, and thus the leading ends of the lead terminals can be sufficiently deeply inserted into the through holes of the printed circuit board.

According to a further preferred embodiment, the connector further comprises positioning means, preferably in the form of recesses and projections which are provided at the positioning member and a printed circuit board, respectively, for securing the positioning member in a specified position on the printed circuit board.

When the connector is connected with the printed circuit board, the connector can be readily positioned on the printed circuit board by the positioning means provided at the positioning member in a position where the lead terminals are in conformity with through holes of the printed circuit board.

Since the connector can be readily positioned on the printed circuit board by the positioning means, the connection can be easily and securely made.

Particularly, if the retaining means is caused to retain the positioning member in its partial mount position, the connector can be smoothly placed and fixed on the printed circuit board by the engaging means. In other words, the circuit board can be easily positioned. If the positioning means is moved to its full mount position, the lead terminals can be easily inserted into the through holes of the printed circuit board.

Preferably, a tapered surface is formed on an edge of each insertion hole at the side from which the lead terminal is inserted, the tapered surface tapering toward the other edge of the insertion hole.

Even if the leading ends of the lead terminals are displaced when the positioning member is mounted in its partial mount position on the housing to insert the leading ends of the lead terminals into the insertion holes, they come into contact with the tapered surface and are guided toward the centers of the insertion holes along the inclination of the tapered surface.

Accordingly, even if the leading ends of the lead terminals are displaced from their specified positions, the displacement can be corrected by the tapered surfaces. Thus, the insertion of the leading ends of the lead terminals into the insertion holes can be smoothly done.

These and other objects, features and advantages of the present invention will become more apparent upon a reading of the following detailed description and accompanying drawings in which:
FIG. 1 is an exploded perspective view of a connector as a first embodiment of the invention,
FIG. 2, corresponding to FIG. 1, is an exploded side view of the connector,
FIG. 3 is a perspective view showing a state where a positioning member is held in its partial mount position,
FIG. 4, corresponding to FIG. 3, is a side view of the connector,
FIG. 5 is a perspective view showing a state where the positioning member is held in its full mount position,
FIG. 6, corresponding to FIG. 5, is a side view of the connector,
FIG. 7 is an exploded perspective view of a connector according to a second embodiment of the invention,
FIG. 8, corresponding to FIG. 7, is an exploded side view of the connector,
FIG. 9 is a perspective view showing a state where the positioning member is held in its partial mount position,
FIG. 10, corresponding to FIG. 9, is a side view of the connector,
FIG. 11 is a perspective view showing a state where the positioning member is held in its full mount position,
FIG. 12, corresponding to FIG. 11, is a side view of the connector,
FIG. 13 is a side view showing a state where the connector is mounted on a printed circuit board,
FIG. 14 is a side view showing a state where the connector is mounted on the printed circuit board with the positioning member held in its partial mount position,
FIG. 15 is a side view of a connector as another embodiment, and

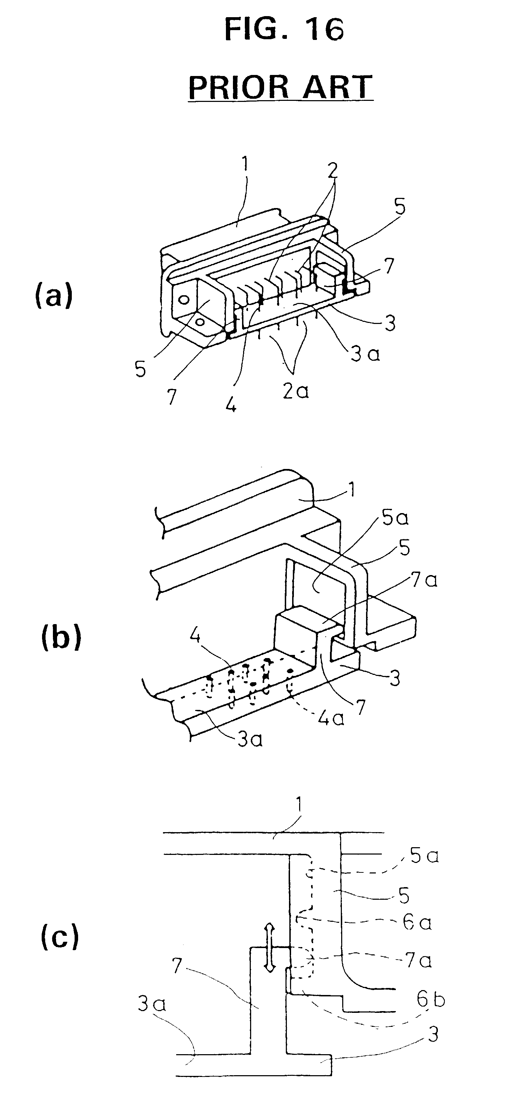

FIGS. 16(a), 16(b) and 16(c) are diagrams of a prior art connector.

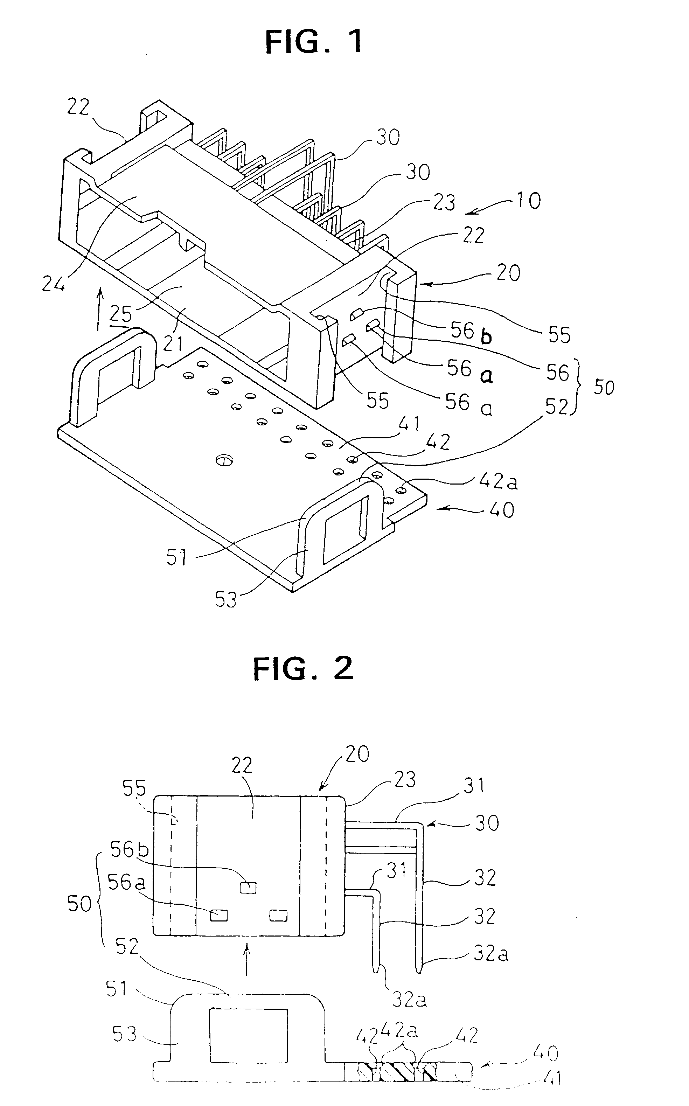

Hereafter, a first embodiment of the invention is described with reference to FIGS. 1 to 6.

In FIGS. 1 and 2, a connector 10 includes a housing 20, lead terminals 30 projecting from the rear surface (right side in FIGS. 1 and 2) of the housing 20, and a positioning member 40 which is detachably mountable on the housing 20 and formed with a plurality of insertion holes 42 into which the plurality of lead terminals 30 are insertable.

The housing 20 is unitarily formed of an insulating material into a box-like shape, and has a bottom wall 21, opposite side walls 22, a rear wall 23 and a top wall 24. An engaging opening 25 into which an unillustrated male connector is mounted is formed at a front part of the housing 20.

The side walls 22, 22 of the housing 20 are parallel to each other, and the outer surfaces thereof act as guide surfaces. Engaging members 51 of the positioning member 40 to be described later are brought into contact with the guide surfaces 22 and held thereat with their opposite lateral ends, with the result that the positioning member 40 is permitted to make a parallel up-and-down movement without being displaced along the lateral direction.

The plurality of lead terminals 30 are mounted such that they project from the rear wall 23 of the housing 20.

Each lead terminal 30 is formed by bending a conductive wire in an L-shape, and includes a horizontal portion 31 secured on the rear wall 23 and a vertical portion 32 having a leading end 32a facing downward.

The positioning member 40 is formed of a substantially rectangular flat insulating plate of an elastically deformable synthetic resin. A narrow rear portion 41 formed with the plurality of insertion holes 42 is formed at a rear part of the positioning member 40.

As many insertion holes 42 as the lead terminals 30 are formed in positions corresponding to the leading ends 32a of the lead terminals 30. The leading ends 32a of the lead terminals 30 are inserted into the respective insertion holes 42 from above. On an upper edge of each insertion hole 42, there is formed a tapered surface 42a which is substantially concentric with the insertion hole 42 and tapered toward the lower end of the insertion hole 42.

The positioning member 40 is mounted on the housing 20 by means of the following construction.

The pair of upward projecting engaging members 51, 51 are formed at the opposite lateral sides on the upper surface of the positioning member 40. The engaging members 51 do not extend over the rear portion 41. Each engaging member 51 includes an engaging portion 52 and supports 53 and is formed in a reverse U-shape. A distance between the inner surfaces of the engaging members 51, 51 is set equal to a distance between the guide surfaces 22, 22 of the housing 20. In other words, the inner surfaces of the engaging members 51 can be brought into contact with the guide surfaces 22.

On the other hand, three projections 56a, 56a and 56b having a semicircular cross-section project outward from each guide surface 22 of the housing 20. These projections 56 and the engaging portions 52 of the engaging members 51 form a retaining means 50 for retaining the positioning member 40 in its partial and full mount positions on the housing 20.

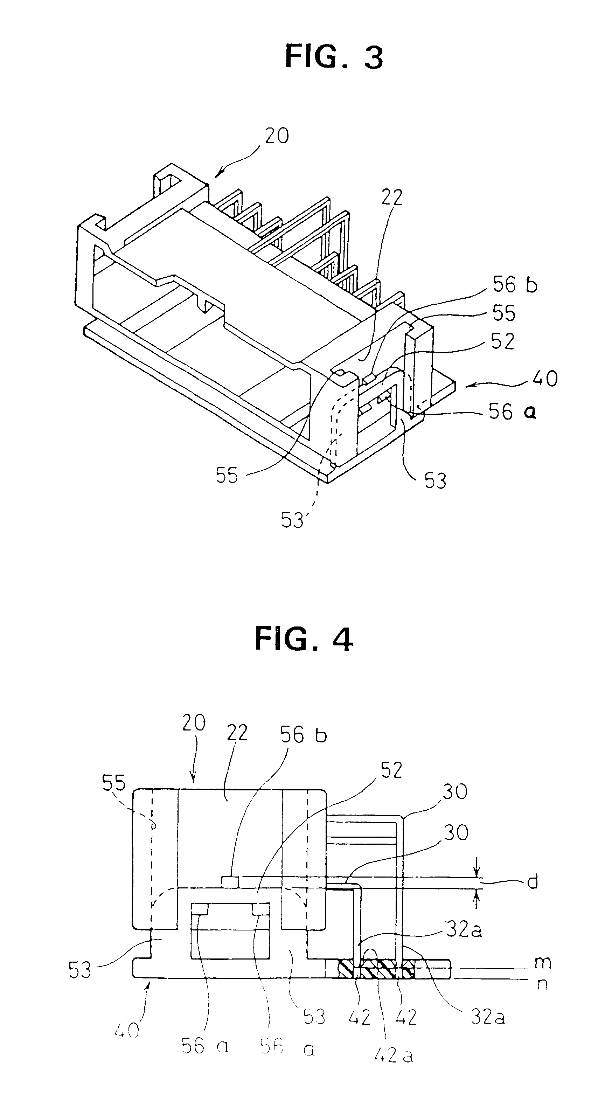

The two projections 56a, 56a are arranged at the same level at a lower part of the guide surface 22, and the other projection 56b is located above these projections 56a, 56a, spaced apart therefrom by a distance equal to the width of the engaging portion 52. Accordingly, the engaging portion 52 can be locked between the projections 56a and 56b as shown in FIGS. 3 and 4.

The height of the projections 56a is set such that the leading ends 32a of the lead terminals 30 are slightly inserted into the insertion holes 42 when the engaging portions 52 are locked as described above.

In other words, the height of the projections 56a is set such that the positioning member 40 is retained or locked in a partial mount position m where the leading ends 32a of the vertical portions 32 of the leads 30 are inserted into the respective holes 42 by a distance m.

A diameter d of the cross-section of the projection 56a is set considerably larger than a distance between the partial mount position m and a position n of the bottom surface of the positioning member 40.

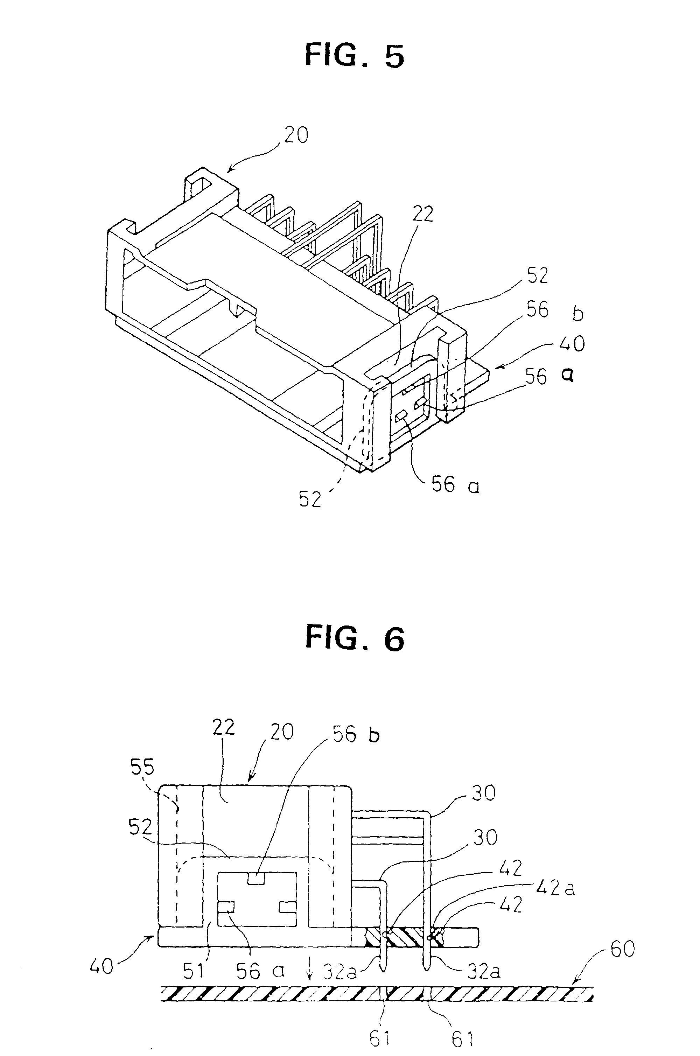

Thus, as shown in FIGS. 5 and 6, the leading ends of the lead terminals 30 project from the insertion holes 42 by a required length when the engaging portions 52 of the engaging members 51 move over the respective projections 56b and are locked thereby.

In other words, the diameter d of the respective projections 56b is set such that the positioning member 40 is retained in its full mount position in such a locked state.

Further, in the housing 20, a pair of vertically extending guide grooves 55, 55 are formed at the front and rear sides of each guide surface 22, respectively. A spacing between the guide grooves 55, 55 is set substantially equal to the spacing between the supports 53. By fitting the supports 53 of the engaging members 51 into the pairs of guide grooves 55, 55, the positioning member 40 is allowed to slide in the vertical direction without being displaced in the forward and backward directions.

The width of the guide grooves 55 (a dimension of the guide grooves 55 in the lateral direction normal to the guide surface 22) is set equal to a sum of the thickness of the engaging member 51 and a projecting distance of the projections 56. Accordingly, the engaging portions 52 are allowed to shift outward while they move over the projections 56. The displacement of the positioning member 40 in the lateral direction (the widthwise direction of the guide grooves 55) with respect to the housing 20 can be prevented by the contact of the engaging members 51, 51 with the guide surfaces 22, 22.

The operation of the thus constructed embodiment is described.

FIGS. 3 and 4 are a perspective view and a side view of the positioning member 40 in its partial mount position m, respectively.

During transportation, the positioning member 40 is partially mounted on the housing 20.

More specifically, as shown in FIGS. 1 and 2, the positioning member 40 is disposed below the housing 20 and moved upward after the engaging members 51 are fitted into the guide grooves 55. As the positioning member 40 is moved upward, the engaging portions 52 move over the projections 56a while undergoing an outward elastic deformation, and are locked between the projections 56a and 56b after returning to their positions in contact with the guide surfaces 22 due to an elastic restoring force.

In this way, the positioning member 40 is held in the partial mount position m, and the leading ends 32a of the lead terminals 30 of the housing 20 are slightly inserted into the insertion holes 42.

During the operation of bringing the positioning member 40 to its partial mount position, the leading ends 32a of the lead terminals 30 are inserted straight into the insertion holes 42 if the leading ends 32a are in conformity with the centers of the corresponding insertion holes 42.

On the contrary, if the centers of the leading ends 32 of the lead terminals 30 are displaced from the centers of the insertion holes 42 due to the disarrangement of the leading ends 32, the leading ends 32 come into contact with the tapered surfaces 42a at the upper edges of the insertion holes 42. However, the leading ends 32 are guided toward the centers of the insertion holes 42 along the inclination of the tapered surfaces 42 and consequently inserted into the insertion holes 42.

As described above, in the connector 10 according to this embodiment, the leading ends 32a of the displaced lead terminals 30 can be smoothly inserted into the insertion holes 42 by the tapered surfaces 42 formed in the insertion holes 42. Therefore, the positioning member 40 can be smoothly mounted on the housing 20, thereby improving workability.

The connector 10 is transported in this state.

The connector 10 may be struck against something, thereby being subjected to an external force.

However, this external force cannot be directly exerted on the leading ends 32 of the lead terminals 30 since they are concealed in and protected by the positioning member 40. Therefore, the leading ends 32a are not bent during transportation.

Since the connector 10 according to this embodiment does not require a special package or the like for preventing the damage of the leading ends 32a during transportation, a transportation cost can be reduced.

After transportation, when the connector 10 is connected with a printed circuit board, the positioning member 40 is moved to its full mount position.

FIGS. 5 and 6 are a perspective view and a side view of the connector when the positioning member is retained in its full mount position.

More specifically, when the positioning member 40 is moved upward until the engaging portions 52 of the engaging members 51 move over the respective projections 56b while undergoing the outward elastic deformation as shown in FIGS. 5 and 6, the engaging portions 52 return to their positions in contact with the guide surfaces 22 due to their elastic restoring force. As a result, the engaging portions 52 are locked by the respective projections 56b. In this way, the positioning member 40 is retained in its full mount position.

As a result, the leading ends 32a of the lead terminals 30 project from the lower surface of the positioning member 40 through the insertion holes 42 by a required length. All the projecting leading ends 32a are aligned, facing downward.

The connector 10 in this state is conveyed to a printed circuit board 60, and the leading ends 32a projecting from the lower surface of the positioning member 40 are inserted into through holes 61. The connector 10 can be electrically connected with the printed circuit board 60 by means of soldering.

Since the projecting ends 32a of the lead terminals 30 are aligned during the connection of the connector 10 according to this embodiment with the printed circuit board 60, they can be easily inserted into the holes 61.

While the engaging portions 52 of the engaging members 51 move over the projections 56a and 56b when the positioning member 40 is engaged with the housing 20 and when the connector 10 is connected with the printed circuit board 60, the engaging members 51 undergo such an elastic deformation that they incline outward in the guide grooves 55. This causes the positioning member 40 and, thus, its rear portion 41 to undergo a slight elastic deformation. The deformation of the positioning member 40 results in a slight deformation and disarrangement of the insertion holes 42.

However, in the connector 10 according to this embodiment, the engaging members 51, 51 are located at the outside of the guide surfaces 22, 22 formed on the opposite lateral side walls of the housing 20. Accordingly, in comparison with the positioning member 3 of the prior art connector in which the engaging members 7 are located on the inside of the guide walls 5 projecting from the front surface of the housing 1, the spacing between the engaging members 51, 51 of the positioning member 40 of this embodiment is longer than the spacing between the engaging members 7, 7 of the prior art positioning member 3 under the condition that the lateral dimension of the housing 20 is equal to that of the prior art housing 1.

Even under the condition that the prior art guide walls 5 were located on the outside of the outer walls of the housing 1 and the spacing between the guide surfaces 22, 22 were equal to the spacing between the prior art guide surfaces 5a, 5a, the spacing between the engaging members 51, 51 of this embodiment would be longer than the spacing between the prior art engaging members 7, 7 by the thickness of the prior art engaging members 7.

Accordingly, if it is assumed that the engaging members 51 of this embodiment are deformed to the same degree as the prior art engaging members 7, the deformation per unit length of the positioning member 40 in the connector 10 according to the invention is smaller than that of the prior art positioning member 3.

Thus, the deformation and the disarrangement of the insertion holes 42 caused by the deformation of the positioning member 40 are more insignificant than in the prior art. As a result, the leading ends 32a of the lead terminals 30 can be aligned with higher accuracy in the connector 10 according to this embodiment.

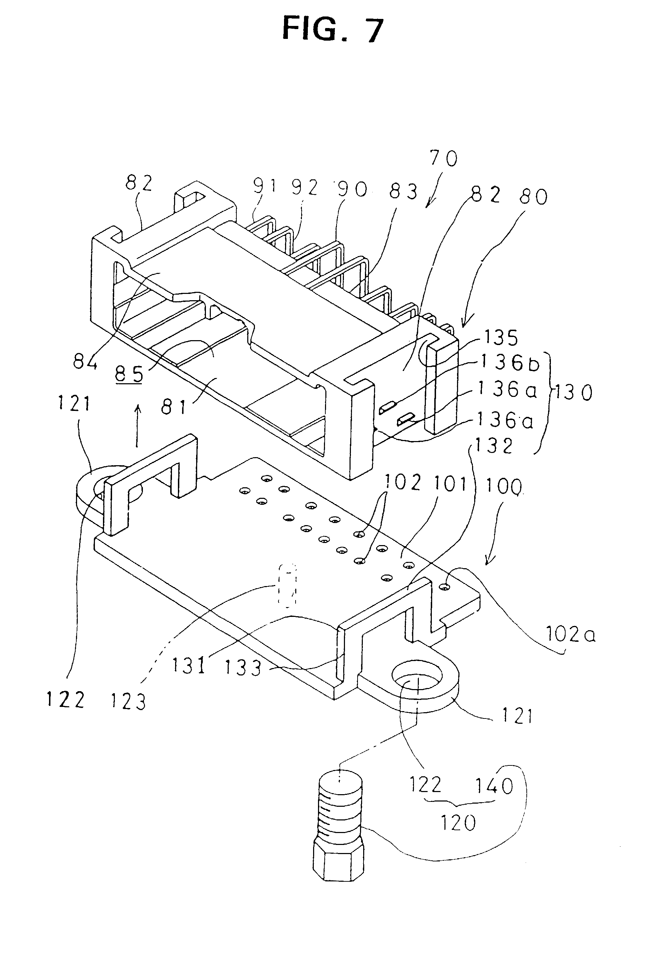

Hereafter, a second embodiment of the invention is described with reference to FIGS. 7 to 14.

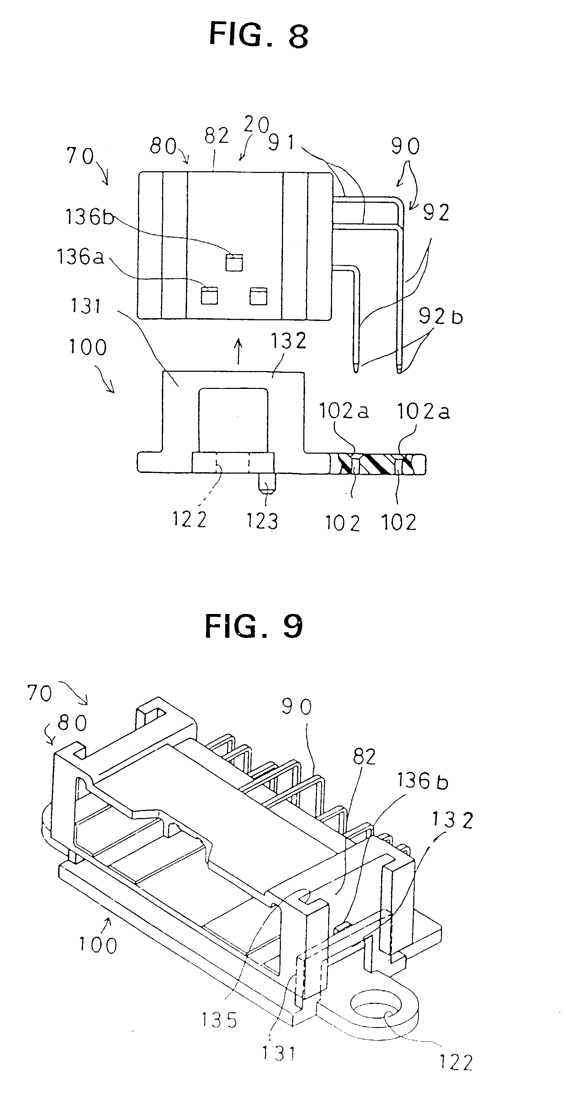

In FIGS. 7 and 8, a connector 70 includes a housing 80, lead terminals 90 projecting from the rear surface of the housing 80, and a positioning member 100 which is detachably mountable on the housing 80 and formed with a plurality of insertion holes 102 into which the plurality of lead terminals 90 are insertable.

The housing 80 is unitarily formed of an insulating material into a box-like shape similar to the housing 20 of the first embodiment, and has a bottom wall 81, opposite side walls 82, a rear wall 83 and a top wall 84. An engaging opening 85 into which an unillustrated male connector is mounted is formed at a front part of the housing 80.

The side walls 82, 82 of the housing 80 are parallel to each other, and the outer surfaces thereof act as guide surfaces. Engaging members 131 of the positioning member 100 to be described later are brought into contact with the guide surfaces 82 and held thereat with their opposite lateral ends, with the result that the positioning member 100 is permitted to make a parallel movement without being displaced in the lateral direction.

The plurality of lead terminals 90 mounted on the housing 80 are similar to the lead terminals 30 of the first embodiment. In other words, each lead terminal 90 is formed by bending a conductive wire in an L-shape, and includes a horizontal portion 91 secured on the rear wall 83 and a vertical portion 92 having a leading end 92a facing downward.

The positioning member 100 has substantially the same construction as the positioning member 40 of the first embodiment. In other words, the positioning member 100 is formed of a substantially rectangular flat insulating plate of an elastically deformable synthetic resin. A narrow rear portion 101 formed with a corresponding number of insertion holes 102 to the number of the lead terminals 90 is formed at a rear part of the positioning member 100. The insertion holes 102 are formed in positions corresponding to the leading ends 92a of the lead terminals 90.

On an upper edge of each insertion hole 102 into which the corresponding leading end 92a of the lead terminal 90 is inserted, there is formed a tapered surface 102a.

The positioning member 100 is mounted on the housing 80 by means of the following construction.

Similar to the first embodiment, the positioning member 100 is formed with a pair of engaging members 131 each including an engaging portions 132 and two supports 133. On the other hand, a pair of guide grooves 135, two projections 136a and a single projection 136b are formed on each guide surface 82 of the housing 80. The projections 136a and the projection 136b are spaced apart by the width of the engaging portion 132. A spacing D between the projections 136a and 136b is longer than a distance between a partial mount position M and a position N of the bottom surface of the positioning member 100. The engaging portions 132 and the projections 136 form a retaining means 130 for retaining the positioning member 100 in its partial and full mount positions on the housing 80.

A spacing between the inner surfaces of the engaging members 131, 131 is set equal to a spacing between the guide surfaces 82, 82 of the housing 80. In other words, the inner surfaces of the engaging members 131 can be brought into contact with the corresponding guide surfaces 82. The width of the guide grooves 135 is set at such a value that the engaging portions 132 are allowed to move over the projections 136 while being deflected outward.

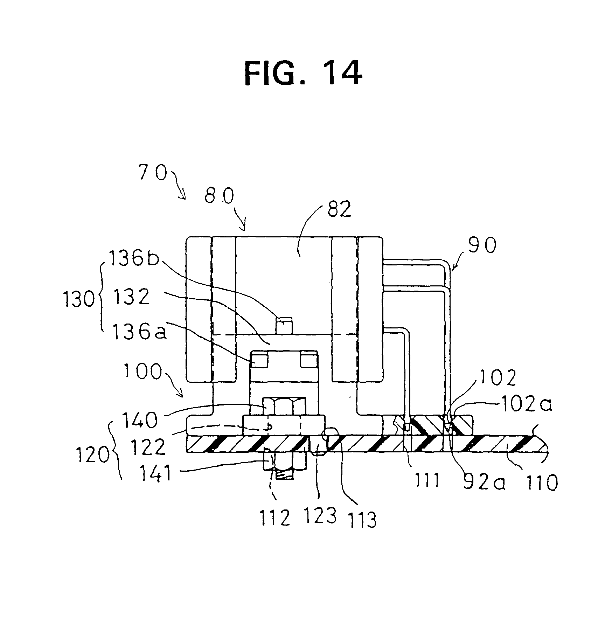

The positioning member 100 of the second embodiment is further formed with a guide projection 123 in a substantially center position of the bottom surface of the positioning member 100. The guide projection 123 projects at a right angle from the bottom surface of the positioning member 100 and is adapted to position the leading ends 92a of the lead terminals 90 in conformity with specified through holes 111 of a printed circuit board 110 when the connector 70 is connected with the printed circuit board 110 (see Fig. 14). The printed circuit board 110 is formed with an engaging hole 113 into which the guide projection 123 of the positioning member 100 is closely fitted.

A wing portion 121 extends from each of opposite lateral ends of the positioning member 100, and has the same thickness as the positioning member 100. Each wing portion 121 is formed with a circular guide hole 122. Screws 140 to be described later and the guide holes 122 form together a screwing means 120. On the other hand, the printed circuit board 110 is formed with positioning holes 112 which are concentric with and in conformity with the guide holes 122.

The screws 140 are inserted through the positioning holes 112, and thread portions of the screws 140 projecting from the positioning holes 112 are spirally fitted into the guide holes 122.

With the guide projection 123 fitted into the engaging hole 113, the guide holes 122 are concentrically in conformity with the positioning holes 112, and the insertion holes 102 of the positioning member 100 are in conformity with the through holes 111 of the printed circuit board 110.

Next, the operation of the thus constructed embodiment is described.

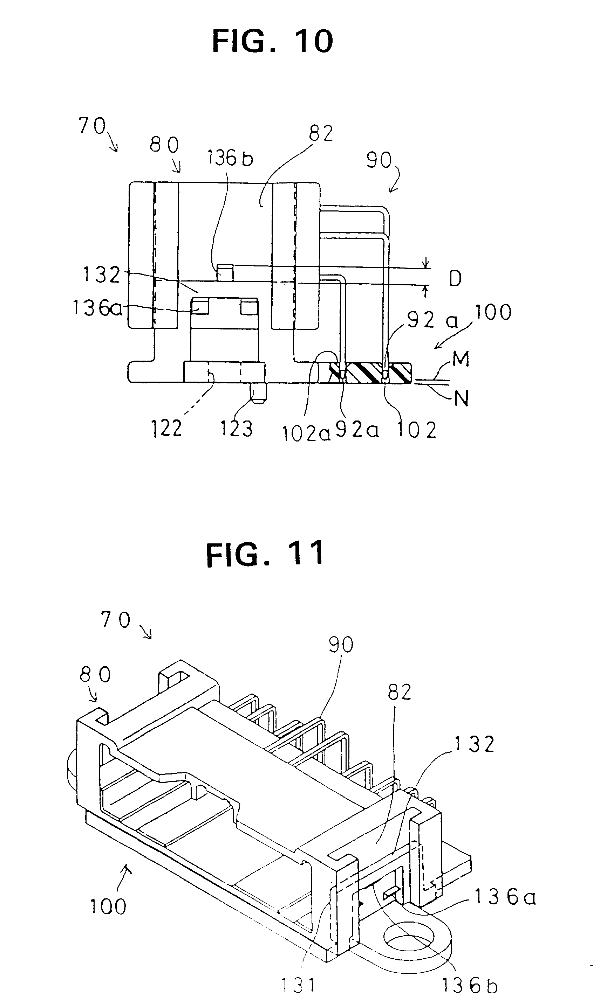

Prior to transportation, the positioning member 100 is disposed below the housing 80 as shown in FIGS. 7 and 8. The positioning member 100 is moved upward after the engaging portions 131 are fitted in the guide grooves 135 in contact with the guide surfaces 82. Then, as shown in FIGS. 9 and 10, the engaging portions 132 move over the projections 136a while undergoing an outward elastic deformation, and the positioning member 100 is partially mounted on the housing 80 such that the engaging members 132 are locked between the projections 136a and 136b. In this way, the positioning member 100 is retained in its partial mount position M where the leading ends 92a of the lead terminals 90 of the housing 80 are slightly inserted into the insertion holes 102.

If the connector 10 is transported with the positioning member 10 in its partial mount position M as shown in FIG. 10, the leading ends 92a are not bent during transportation even if the connector 70 is struck against something and is therefore subjected to an external force. This is because they are concealed in and protected by the positioning member 100. Since the connector 70 does not require a special package or the like for preventing the damage of the leading ends 92a during transportation, a transportation cost can be reduced.

After transportation, when the connector 70 is connected with the printed circuit board 110, the positioning member 100 is moved until the engaging portions 132 of the engaging members 131 are locked by the projections 136b after moving over the projections 136b while undergoing the outward elastic deformation. In this way, the positioning member 100 is retained in its full mount position. As a result, the leading ends 92a of the lead terminals 90 are aligned, projecting from the bottom surface of the positioning member 100 through the insertion holes 102 by a required length.

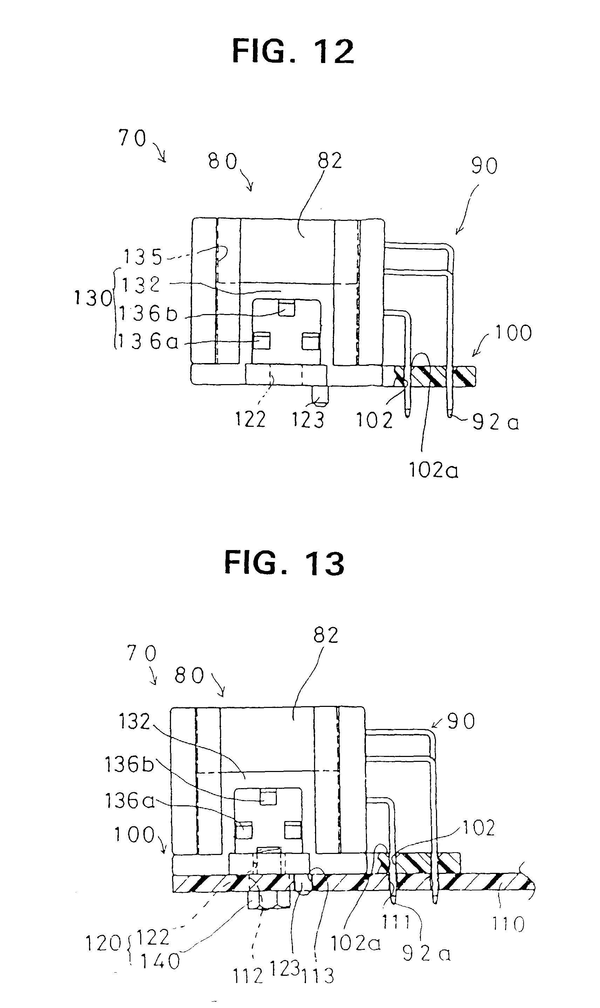

After the connector 70 is placed on the printed circuit board 110, the screws 140 are inserted into the positioning holes 112 from the underneath of the printed circuit board 110, and the thread portions at the leading ends of the screws 140 are spirally engaged with the guide holes 122. As the screws 140 are turned, the connector 70 gradually moves closer to the printed circuit board 110, and the leading ends 92a of the lead terminals 90 projecting from the positioning member 100 are inserted into the through holes 111. This state is shown in FIG. 13.

At this stage, the guide projection 123 of the positioning member 100 is located in the engaging hole 113 of the printed circuit board 110, thereby positioning the leading ends 92a of the lead terminal 90 in conformity with the through holes 111. Since the positioning member 100 gradually comes closer to the printed circuit board 110 as the screws 140 are turned, this positioning can be more easily performed. Although the screws 140 are spirally engageable with the positioning member 100 in this embodiment, they may be spirally engageable with the housing 80 such that the housing 80 comes closer to the printed circuit board 110 as the screws 140 are turned. With this arrangement, an operation of pressing the housing 80 against the positioning member 100 and an operation of fixing the connector 70 to the printed circuit board 110 can be simultaneously performed by fastening the screws 140 after the connector 70 is placed on the printed circuit board 110 with the positioning member 100 partially mounted on the housing 80.

The connector 70 is positioned and secured in a specified position on the printed circuit board 110 in the above procedure.

As is clear from the above description, when the connector 70 according to this embodiment is connected with the printed circuit board 110, the lead terminals 90 can be positioned in conformity with the corresponding through holes 111 without being brought into contact with the surface of the printed circuit board 110. Therefore, the connector 70 can be easily and securely connected with the printed circuit board 110.

Further, since the connector 70 and the printed circuit board 110 are securely brought into close contact with each other by the screws 140 and the guide holes 122, the leading ends 92a of the lead terminal 90 can be sufficiently deeply inserted into the through holes 111 of the printed circuit board 111, thereby realizing a secure connection.

The above description refers to a case where the connector 70 is connected with the printed circuit board 110 after the positioning member 100 is positioned in its full mount position.

However, the connection can also be made as follows. The connector 70 in which the positioning member 100 is held in its partial mount position as shown in FIG. 10 is fixed on the printed circuit board 110 while being positioned by means of the guide projection 123 (state shown in Fig. 14). Thereafter, the housing 80 is pressed downward toward the printed circuit board 110 to insert the leading ends 92a of the lead terminals 90 into the through holes 111, thereby realizing the state as shown in FIG. 13. The advantage of this sequence of operation is that the lead terminals 90 are protected by the positioning member 100 at any time until they are inserted into the respective holes 111.

Even in this case, the connector 70 is positioned in a specified position on the printed circuit board 110. Thus, the lead terminals 90 can be securely inserted into the through holes 111 without being brought into contact with the surface of the printed circuit board 110.

Similar to the first embodiment, the engaging members 131 are located at the outside of the side walls 82 of the housing 80 in the connector 70 of this embodiment. Accordingly, the elastic deformation per unit length of the positioning member 100 can be suppressed which is caused by the elastic deformation of the engaging members 131 when the engaging portions 132 of the engaging members 131 move over the projections 136. Thus, the deformation and the disarrangement of the insertion holes 102 caused by the elastic deformation of the positioning member 100 can also be suppressed to a small degree. As a result, the leading ends 92a of the lead terminals 90 can be aligned with a higher accuracy in the connector 70 of this embodiment.

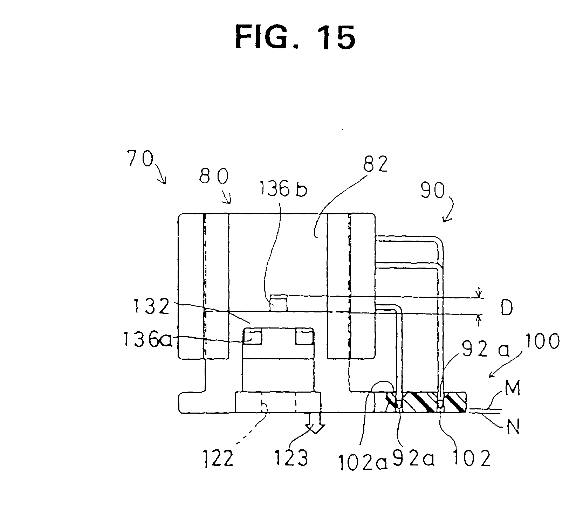

The present invention is not limited to the above described and illustrated embodiments.
(1) Although the second embodiment is described with respect to the case where both the circuit board positioning means (guide projection 123) and the screwing means 120 are provided, only either one of them may be provided according to the invention.
   If only the circuit board positioning means is provided, the connector is securely positioned in the specified position on the printed circuit board. Accordingly, the lead terminals can be securely inserted into the through holes without being brought into contact with the surface of the printed circuit board.
   If only the screwing means is provided, the connector can be mounted on the printed circuit board in close contact therewith, the lead terminals can be inserted sufficiently deeply into the through holes. Further, by setting the inner diameter of the holes through which the screws are inserted equal to the outer diameter of the screws, the positioning can be done by the screws.
(2) Although the second embodiment is described with respect to the case where the holes 122 of the wing portions 121 are used as a part of the screwing means, the positioning member may be brought into close contact with the printed circuit board by screws and nuts.
(3) The foregoing embodiments are described with respect to the case where the projections are formed on the guide surfaces of the housing and the engaging portions of the engaging members move over these projection. However, the invention may also be applied to the following connectors: one in which projections are formed on both of the guide surfaces and the engaging members, and the positioning member is retained in a specified position by the contact of the leading ends of the projections of the engaging members with the guide surfaces and by the engagement of the projections of the engaging members with those of the guide surfaces; and one in which recesses and projections are formed on the guide surfaces and the engaging members, respectively, and the positioning member is retained in a specified position by the engagement of the projections with the recesses.
(4) Although the second embodiment is described with respect to the case where the cylindrical guide projection 123 having a flat surface is fitted into the engaging hole 113 formed in the printed circuit board 110, the guide projection 123 may be provided with a snapping means for snapping into holes in the circuit board as shown in FIG. 15. With this type of guide projection 123, the connector 70 can be secured on the printed circuit board 110 without using the screwing means.

## Claims

1. A connector (10;70) for a printed circuit board, comprising:
a housing (20;80) from which a plurality of lead terminals (30;90) project,
a positioning member (40;100) formed with a plurality of insertion holes (42;102) into which the lead terminals (30;90) are insertable,
guide surfaces (22;82) formed at opposite lateral sides of the housing (20;80), the plurality of lead terminals (30;90) being located between the opposite lateral sides,
the position member (40;100) comprising engaging members (51;131) which are to be guided along the guide surfaces (22;82) in a direction in which the lead terminals (30;90) project, and are elastically deformable away from the guide surfaces (22;82), and
retaining means (56, 52 ; 136, 132) formed at the guide surfaces (22;82) and the engaging members (51;131), respectively, for retaining the positioning member (40;100) in a partial mount position where the lead terminals (30;90) are slightly inserted into the insertion holes (42;102), and in a full mount position where the lead terminals (30;90) project from the positioning member (40;100) through the insertion holes (42;102) by a required length, characterised in that said guide surfaces (22; 82) are directed towards the outside of the housing (20; 80).

2. A connector according to claim 1, further comprising mechanical fixing means (120) for fixing the connector (70) to a printed circuit board (110).

3. A connector according to claim 2, wherein the mechanical fixing means is formed by screwing means (120).

4. A connector according to claim 3, wherein the screwing means comprises at least one screw (140) which is inserted from the underneath of the printed circuit board (110) and is spirally engaged with the positioning member (40;100) or the housing (20;80).

5. A connector according to claim 3 or 4, wherein the screwing means is adapted to position the connector (70) to the printed circuit board (110).

6. A connector according to any of claims 1 to 5, further comprising a positioning means (123) which is provided at the positioning member (100) for positioning the positioning member in a specified position on the printed circuit board.

7. A connector according to claim 6, wherein the positioning means is formed by a guide projection (123) projecting from the bottom surface of the positioning member (100), and insertable into a positioning hole (113) in the printed circuit board (110).

8. A connector according to claim 7, wherein the guide projection (123) is provided with fixing means for fixing the connector (70) to the printed circuit board (110).

9. A connector according to any of claims 1 to 8, wherein a tapered surface (42a;102a) is formed on an edge of each insertion hole (42;102) at the side from which the respective lead terminal (30;90) is inserted, the tapered surface (42a;102a) tapering toward the other edge of the insertion hole (42;102).

## Patentansprüche

1. Verbinder (10; 70) für eine gedruckte Schaltungs- bzw. Leiterplatte mit: einem Gehäuse (20; 80), von dem sich eine Vielzahl von Leitungsanschlüssen (30; 90) erstreckt,
einem Positionierungselement (40; 100), welches mit einer Vielzahl von Einsetzlöchern (42; 102) ausgebildet ist, in welche die Leitungsanschlüsse (30; 90) einsetzbar sind,
Führungsflächen (22; 82), welche an entgegengesetzten lateralen Seiten des Gehäuses (20; 80) ausgebildet sind, wobei die Vielzahl von Leitungsanschlüssen (30; 90) zwischen den entgegengesetzten lateralen Seiten angeordnet ist,
wobei das Positionierungselement (40; 100) vorgesehen ist mit Eingriffselementen (51; 131), welche entlang der Führungsflächen (22; 82) in einer Richtung geführt werden, in der die Leitungsanschlüsse (30; 90) hervorragen, und elastisch von den Führungsflächen (22; 82) weg verformbar sind, und
Rückhaltemitteln (56, 52; 136, 132), welche an den Führungsflächen (22; 82) bzw. den Eingriffselementen (51; 131) ausgebildet sind zum Zurückhalten des Positionierungselementes (40; 100) in einer teilweise angebrachten Position, in der die Leitungsanschlüsse (30; 90) leicht eingesetzt sind in die Einsetzlöcher (42; 102) und in einer vollständig angebrachten Position, in der die Leitungsanschlüsse (30; 90) von dem Positionierungselement (40; 100) durch die Einsetzlöcher (42; 102) in einer gewünschten Länge hervorragen, dadurch gekennzeichnet,
daß die Führungsflächen (22; 82) zu der Außenseite des Gehäuses (20; 80) gerichtet sind.

2. Verbinder gemäß Anspruch 1, ferner ein mechanisches Befestigungsmittel (120) zum Befestigen des Verbinders (70) an einer gedruckten Leiterplatte (110) umfassend.

3. Verbinder gemäß Anspruch 2, bei welchem das mechanische Befestigungsmittel durch ein Schraubmittel (120) ausgebildet wird.

4. Verbinder gemäß Anspruch 3, bei welchem das Schraubmittel wenigstens eine Schraube (140) umfaßt, welche von der Unterseite der gedruckten Leiterplatte (110) eingesetzt ist und spiralförmig in Eingriff ist mit dem Positionierungselement (40; 100) oder dem Gehäuse (20; 80).

5. Verbinder gemäß Anspruch 3 oder 4, bei welchem das Schraubmittel angepaßt ist, um den Verbinder (70) an der gedruckten Leiterplatte (110) zu positionieren.

6. Verbinder gemäß einem der Ansprüche 1 bis 5, ferner ein Positionierungsmittel (123) umfassend, welches vorgesehen ist, an dem Positionierungselement (100) zum Positionieren des Positionierungselementes in einer spezifische Position an der gedruckten Leiterplatte.

7. Verbinder gemäß Anspruch 6, bei welchem das Positionierungsmittel durch einen Führungsvorsprung (123) ausgebildet wird, welcher von der Bodenfläche des Positionierungselementes (100) hervorragt und einsetzbar ist in ein Positionierungsloch (113) in der gedruckten Leiterplatte (110).

8. Verbinder gemäß Anspruch 7, bei welchem der Führungsvorsprung (123) vorgesehen ist mit einem Befestigungsmittel zum Befestigen des Verbinders (70) an der gedruckten Leiterplatte (110).

9. Verbinder gemäß einem der Ansprüche 1 bis 8, bei welchem eine konische bzw. sich verjüngende Fläche (42a; 102a) an einer Kante jedes Einsetzloches (42; 102) ausgebildet ist an der Seite, von der der jeweilige Leitungsanschluß (30; 90) eingesetzt wird, wobei die konische Fläche (42a; 102a) konisch bzw. verjüngend zu der anderen Kante des Einsetzloches (42; 102) zuläuft.

## Revendications

1. Connecteur (10 ; 70) pour carte à circuit imprimé, comprenant :
un boîtier (20 ; 80) dont une pluralité de bornes formant des sorties (30 ; 90) font saillie,
un élément de positionnement (40 ; 100) doté d'une pluralité de trous d'insertion (42 ; 102) dans lesquels les bornes formant des sorties (30 ; 90) peuvent être insérées,
des surfaces de guidage (22 ; 82) formées au niveau de côtés latéraux opposés du boîtier (20 ; 80), la pluralité de bornes formant des sorties (30 ; 90) étant placée entre les côtés latéraux opposés,
l'élément de positionnement (40 ; 100) comprenant des éléments de venue en prise (51 ; 131) qui doivent être guidés le long des surfaces de guidage (22 ; 82) dans la direction dans laquelle les bornes formant des sorties (30 ; 90) font saillie, et qui sont élastiquement déformables de façon à s'écarter des surfaces de guidage (22 ; 82), et
des moyens de retenue (56, 52 ; 136, 132) respectivement formés au niveau des surfaces de guidage (22 ; 82) et des éléments de venue en prise (51 ; 131) afin de retenir l'élément de positionnement (40 ; 100) dans une position de montage partiel où les bornes formant des sorties (30 ; 90) sont légèrement insérées dans les trous d'insertion (42 ; 102), et dans une position de montage complet où les bornes formant des sorties (30 ; 90) font saillie de l'élément de positionnement (40 ; 100) au travers des trous d'insertion (42 ; 102) sur une longueur voulue,
caractérisé en ce que lesdites surfaces de guidage (22 ; 82) sont dirigées vers l'extérieur du boîtier (20 ; 80).

2. Connecteur selon la revendication 1, comprenant en outre un moyen de fixation mécanique (120) servant à fixer le connecteur (70) à une carte à circuit imprimé (110).

3. Connecteur selon la revendication 2, où le moyen de fixation mécanique est formé par un moyen de vissage (120).

4. Connecteur selon la revendication 3, où le moyen de vissage comprend au moins une vis (140) que l'on insère depuis l'envers de la carte à circuit imprimé (110) et qui vient en prise, hélicoïdalement, avec le moyen de positionnement (40 ; 100) ou le boîtier (20 ; 80).

5. Connecteur selon la revendication 3 ou 4, où le moyen de vissage est conçu pour positionner le connecteur (70) par rapport à la carte à circuit imprimé (110).

6. Connecteur selon l'une quelconque des revendications 1 à 5, comprenant en outre un moyen de positionnement (123) qui est prévu au niveau de l'élément de positionnement (100) afin de positionner l'élément de positionnement dans une position spécifiée sur la carte à circuit imprimé.

7. Connecteur selon la revendication 6, où le moyen de positionnement est formé par une partie saillante de guidage (123) qui fait saillie de la surface de fond de l'élément de positionnement (100), et qui peut être insérée dans un trou de positionnement (113) ménagé dans la carte à circuit imprimé (110).

8. Connecteur selon la revendication 7, où la partie saillante de guidage (123) est dotée d'un moyen de fixation servant à fixer le connecteur (70) à la carte à circuit imprimé (110).

9. Connecteur selon l'une quelconque des revendications 1 à 8, où une surface allant en s'amincissant (42a ; 102a) est formée sur un bord de chaque trou d'insertion (42 ; 102) du côté depuis lequel la borne formant une sortie (30 ; 90) respective est insérée, la surface qui va en s'amincissant (42a ; 102a) allant en s'amincissant en direction de l'autre bord du trou d'insertion (42 ; 102).
